# EUROPEAN PATENT SPECIFICATION

(11) **EP 1 080 053 B1**
(45) Date of publication and mention of the grant of the patent: **21.08.2002**
(21) Application number: 99916102.9
(22) Date of filing: 15.04.1999
(51) Int. Cl.: C04B 41/89, H01L 27/01

(54) **FERROELECTRIC THICK-LAYER STRUCTURES BASED ON LEAD PEROVSKITES AND METHOD FOR THEIR PRODUCTION**
FERROELEKTRISCHE DICKSCHICHT-STRUKTUREN AUF BASIS VON BLEI-PEROVSKITEN UND VERFAHREN ZU DEREN HERSTELLUNG
STRUCTURES A COUCHES EPAISSES FERROELECTRIQUES UTILISANT DES PEROVSKITES DE PLOMB ET LEUR PROCEDE DE PRODUCTION

(30) Priority: 24.04.1998 SI 9800124
(43) Date of publication of application: 07.03.2001
(73) Proprietor: INSTITUT " JOZEF STEFAN", 1000 Ljubljana (SI)
(72) Inventor: HOLC, Janez, 1000 Ljubljana (SI); KOSEC, Marija, 1216 Smlednik (SI); DRNOVSEK, Silvo, 1000 Ljubljana (SI)
(74) Representative: von Füner, Alexander, Prof.h.c. Dr.
(86) International application number: SI9900010
(87) International publication number: WO99055642

(56) References cited:
- US-A- 4 772 985
- US-A- 5 736 759
- US-A- 5 817 170
- PATENT ABSTRACTS OF JAPAN vol. 017, no. 683 (E-1477), 15 December 1993 (1993-12-15) & JP 05 234809 A (SHARP CORP), 10 September 1993 (1993-09-10)

## Description

The present invention relates to ferroelectric thick-layer structures based on lead perovskites on an aluminium oxide substrate or substrate and the method for their production. The invention is in the fields of materials chemistry and electrical engineering.

Ferroelectric ceramics or elements with thick-layer structures based on lead perovskites on an aluminium oxide substrate or substrate are used in the electronics industry as material for the production of sensors, actuators and modulators, and for printing. Lead perovskites include for example lead titanate, lead zirconate titanate, lanthanum - lead titanate zirconate, magnesium - lead niobate, nickel - lead niobate. These materials can be used to produce optical components, electromechanical parts, piezomotors, microposition actuators, pyroelectric sensors of infrared radiation, memory elements, printing cylinders, etc. Components produced from ferroelectric ceramics based on lead perovskites are installed in telecommunications equipment, measuring, analytical, graphical and other types of equipment.

Ferroelectric elements are produced in the form of plates, disks, cylinders and rolls or in the form of layers applied to a substrate with an electrode. In addition to miniaturisation, the advantage of the application of layers to a substrate lies above all in the fact that lower voltages are required to change the polarity of the ferroelectric material. This is primarily important for components in which the direction of polarity changes during operation. Typical layer thicknesses range from 0.1 µm to a few 100 µm, depending on the technology of layer application onto the substrate. Layers up to a few micrometers thick are referred to as thin, while those ranging from a few micrometers up to a few 100 micrometers are referred to as thick. Thick-layer structures can be used for example for sensors. actuators, micromotors and printing elements.

The material chosen as a substrate for the application of thick ferroelectric layers based on. lead perovskites may not react chemically with the substrate at the firing temperature. and its temperature expansion coefficient must be similar to that of the ferroelectric layers. Most frequently, materials based on aluminium oxide, e.g. corundum, are used as the substrate. Electrode must be chemically compatible with the carrier material and the ferroelectric layer at the layer firing temperature. Since this temperature ranges between 900 and 1200°C, materials useful for electrode production include precious metals and their alloys, such as e.g. platinum, gold, or silver-palladium alloys.

As electrode is frequently used pure platinum. Due to the porosity of platinum electrode, reactions occur between the ferroelectric lead perovskite layer and the aluminium oxide substrate. Beta aluminium oxide compounds are produced on the boundary between the platinum layer and the substrate, forcing the platinum layer away. This results in poor adhesion between the platinum electrode and the aluminium oxide substrate. The adhesion is so poor that it prevents use of the structure in practice. The layers delaminate and the tensile strength of the joint between the platinum layer and the aluminium oxide substrate is < 10 N/cm², while adhesion between the ferroelectric layer and platinum is very good. The above-mentioned reactions also result in a change of the composition of the lead perovskite and, concurrently, changes in their ferroelectric properties.

It was noticed that adhesion between lead perovskites and the aluminium oxide substrate is. very good in the absence of a platinum electrode, because compounds based on beta aluminium oxide are not formed.

The costs of layer production with the method used at present are high, above all due to the high price of precious metals. In order to be able to produce cheaper electrodes, such as for example from a silver-palladium alloy with a high amount of silver, the firing temperature of lead perovskites must be reduced to below 900°C. This is achieved by adding glass or other substances, but it also impairs the functional properties of the layers. The problem could be solved by using cheaper electrode which could be fired at higher temperatures.

The known method for the production of thick layers on a carrier material is as follows: application of the electrode, firing, application of the ferroelectric layer and its firing. Consecutive printing of all layers and subsequent simultaneous firing of the entire thick-layer structure would simplify this process, but this is not possible as yet. Namely, concurrent densification of the electrode and the ferroelectric layer occurs during the firing process wherein that of the electrode is slower. This results in a strong and harmful reaction between the ferroelectric layer and the aluminium oxide substrate. US-A-4 772 985 refers to a thick-film capacitor comprising a sintered layer of a ferroelectric material having a perovskite structure and an inorganic binder for sintering said ferroelectric compound without destroying the perovskite structure thereof and at least one electrode formed by printing a metal paste selected from the group of precious metals on each surface of said sintered layer of the ferroelectric material.

The task and objective of the present invention is to produce a mechanically stable and dense ferroelectric thick layer or a thick-layer structure based on lead perovskites on an aluminium oxide substrate in any form, e.g. plate, roll, cylinder, etc., and the method for their production by using a cheaper electrode and simultaneous firing.

According to the invention, this task was solved according to independent claims.

Ferroelectric thick-layer structures according to the invention exploit the good adhesion between lead perovskites and the aluminium oxide substrate, and between lead perovskites and platinum. This serves to avoid the formation of a mechanically unstable joint between platinum and the aluminium oxide substrate in ferroelectric thick-layer structures based on lead perovskites. Precious metal electrodes were replaced with those made of a composite of a precious metal and a lead perovskite. The process for the production of a thick-layer structure was simplified by consecutive printing of layers and simultaneous firing.

The invention will be described with embodiment examples and figures.
Figure 1 presents a comparative thick-layer structure according to the prior art.
Figure 2 presents first an embodiment of a thick-layer structure according to the invention.
Figure 3 presents second an other embodiment of a thick-layer structure according to the invention.

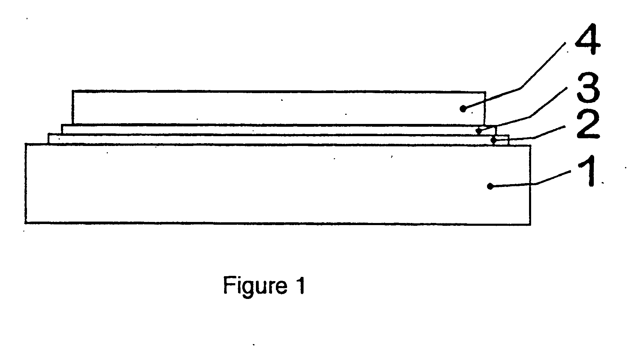

In Figure 1 is presented a comparative ferroelectric thick-layer structure based on a lead perovskite consists of a layer (4) of a ferroelectric lead perovskite on an aluminium oxide substrate (1). Between the electrode (3) made of a precious metal and the substrate (1) there is an intermediary layer (2) of a lead perovskite.

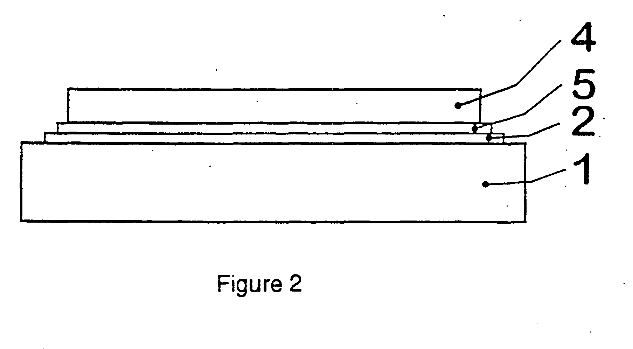

According to the invention as presented in Figure 2, a ferroelectric thick-layer structure based on a lead perovskite consists of a layer (4) of a ferroelectric lead perovskite on an aluminium oxide substrate (1). Between the electrode (5), made of a composite of a precious metal and a lead perovskite, and the substrate (1) there is an intermediary layer (2) of a lead perovskite.

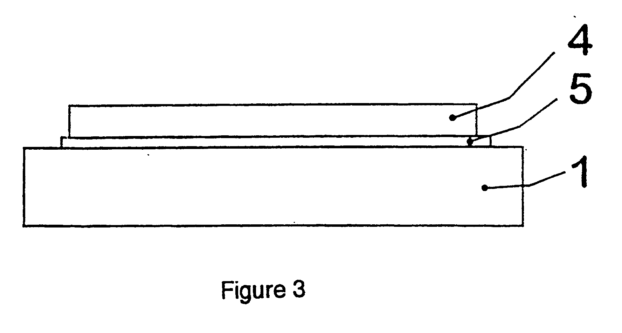

According to the invention as presented in Figure 3, a ferroelectric thick-layer structure based on a lead perovskite consists of a layer (4) of a ferroelectric lead perovskite on an aluminium oxide substrate (1) and an electrode (5) made of a composite of a precious metal and a lead perovskite.

The method for the preparation of ferroelectric thick-layer structures based on lead perovskites with the addition of lead oxide (PbO) in the molar share up to 20 %, preferably from 4 to 10 %, is described in that on an aluminium oxide substrate (1), an intermediary layer (2) of a lead perovskite is applied. Screen printing is a suitable method of application, but other techniques can also be used, e.g. immersion, pouring or spraying. The intermediary layer (2) of a lead perovskite is then fired, preferably in a closed or covered vessel, at a temperature which produces closed porosity. On that layer (2), a layer of a precious metal, e.g. platinum, is applied as an electrode (3 or 5) using the above-mentioned techniques and it is then fired at a temperature which depends on the chemical composition of the lead perovskite. For example, if lanthanum - lead zirconate titanate is used as the intermediary layer (2), the temperature for platinum electrode firing (3 or 5) is from 1000 to 1200°C, while the duration of firing is 0 - 16 hours. A lead perovskite layer (4) is applied to the fired electrode (3 or 5) and firing is performed, preferably in a closed or covered vessel, depending on the composition of the lead perovskite, for 0 - 16 hours in a temperature range of from 900 to 1200°C. The duration of firing (0) is the time required for heating up to a certain temperature and, immediately afterwards, cooling. The firing is performed in atmosphere of lead oxide which is the product of evaporation of added lead oxide (PbO) in a closed or covered vessel.

According to the invention, a mixture of a precious metal and a lead perovskite with a mass share of the precious metal of 60-80% is used for the electrode (5) instead of a pure precious metal. The electrode (5) according to Figure 3 is electrically conductible after firing. If lead perovskites are fired to closed porosity at a temperature up to 1050°C, gold can be used for electrode material instead of platinum. In this case there is no need for an intermediate lead perovskite layer between the aluminium oxide substrate (1) and the electrode (5) of gold.

The entire ferroelectric thick-layer structure can also be produced by the consecutive application of an intermediary layer (2) of a lead perovskite, the electrode (5) of a composite of a precious metal and a lead perovskite and a ferroetectric layer (4) of a lead perovskite, and their firing at a temperature between 900 and 1200°C, depending on the composition of the lead perovskite and the type of the electrode (5).

The invention will be additionally described with embodiment examples.

### Comparative Example 1

A paste for screen printing is first prepared from a lanthanum - lead zirconate titanate powder with a composition of La_{0.08}Pb_{0.88}(Ti_{0.65}Zr_{0.65})O₃(PLZT), to which PbO is added in a 6% molar share with an average particle size of about 1 µm.

The described PLZT paste is applied to create an intermediary layer of up to 20 µm and then fired in a covered vessel for 0 - 16 hours in an atmosphere rich, in lead oxide to closed porosity at a temperature between 900 and 1200°C.

Platinum paste for the electrode is applied as many times as is necessary to achieve a layer thickness of 5 -15 µm. It is fired for 0 - 4 hours at a temperature of up to 1250°C.

The PLZT paste then is applied over it as many times as is necessary to achieve a ferroelectric PLZT layer thickness of up to 80 µm. Printed paste is fired in a covered vessel for 0 - 16 hours at a temperature of up to 1200°C in an atmosphere rich in lead oxide. The athmosphere of lead oxide is the product of evaporation of added lead oxide (PbO) in a covered vessel.

The polarisation of such a ferroelectric PLZT layer is up to 25 µC/cm², its coercive field is 5 kV/cm and its relative dielectric constant is 5000. Its resistance to platinum and PLZT layer peeling from the aluminium oxide substrate is higher than 2000 N/cm².

### Example 1

The method for the preparation is the same as in the comparative Example 1, with the exception that a paste prepared from a composite of platinum and PLZT with a platinum mass share of over 60% is used as the electrode instead of the platinum paste.

The polarisation of such a ferroelectric PLZT layer is up to 25 µC/cm², its coercive field is 5 kV/cm and its relative dielectric constant is 5000. Its resistance to platinum and PLZT layer peeling from the aluminium oxide substrate is higher than 2000 N/cm².

### Example 2

The method for the preparation is the same as in the comparative Example 1, but all layers are printed in succession and the entire thick-layer structure on the substrate is fired for 0 - 16 hours at a temperature up to 1200°C in an atmosphere rich in lead oxide. The material described in Example 2 can be used as the electrode.

The polarisation of such a ferroelectric PLZT layer is up to 30 µC/cm², its coercive field is 5 kV/cm and its relative dielectric constant is 5000. Its resistance to platinum and PLZT layer peeling from the aluminium oxide substrate is higher than 2000 N/cm².

### Comparative Example 2

A gold paste is used as the electrode material and applied using the screen printing technique as many times as is necessary to achieve a layer thickness of 5 - 15 µm. The PLZT layer is then applied over it as many times as is necessary to achieve a ferroelectric layer thickness of up to 80 µm. The printed layers are fired for 0 - 16 hours at a temperature of up to 1050°C in an atmosphere rich in lead oxide.

The polarisation of such a ferroelectric PLZT layer is up to 15 µC/cm², its coercive field is 5 kV/cm and its relative dielectric constant is 5000. Its resistance to platinum and PLZT layer peeling from the aluminium oxide substrate is higher than 2000 N/cm².

### Example 3

The method for the preparation is the same as in the comparative Example 2 but a paste prepared from a composite of gold and PLZT with a gold mass share of over 60% is used instead of the gold paste.

The polarisation of such a ferroelectric PLZT layer is up to 20 µC/cm², its coercive field is 5 kV/cm and its relative dielectric constant is 5000. Its resistance to platinum and PLZT layer peeling from the aluminium oxide substrate is higher than 2000 N/cm².

### Example 4

The method for the preparation is the same as in the comparative Example 2, but after application, the layer of a gold - lead perovskite composite is fired for 0 - 16 hours at a temperature up to 1050°C in an atmosphere rich in lead oxide, then a layer of lead perovskite is applied over it up to a thickness of 80 µm and fired for 0 - 16 hours at a temperature up to 1050°C in an atmosphere rich in lead oxide.

The polarisation of such a ferroelectric PLZT layer is up to 15 µC/cm², its coercive field is 5 kV/cm and its relative dielectric constant is 5000. Its resistance to platinum and PLZT layer peeling from the aluminium oxide substrate is higher than 2000 N/cm².

## Claims

1. Ferroelectric thick-layer structure based on lead perovskites, wherein an intermediate layer (2) of a lead perovskite is applied to an aluminium oxide substrate (1), then the electrode (5) and a layer (4) of a ferroelectric lead perovskite are applied, **characterized in that** the electrode (5) is made of a composite of a precious metal and a lead perovskite with a mass share of the precious metal of over 60%, or in such a proportion that enables the electrode to be electrically conductive.

2. Method for the production of a ferroelectric thick-layer structure according to claim 1, **characterized in that** an intermediate layer (2) of a lead perovskite is applied to an aluminium oxide substrate (1) and fired to closed porosity in an atmosphere rich in lead oxide, then an electrode (5) is applied and fired at a temperature of up to 1200°C and then a final layer (4) of a lead perovskite is applied up to a thickness of 80 µm and fired at a temperature of up to 1200°C in an atmosphere rich in lead oxide.

3. Method according to claim 2, **characterized in that** a composite of platinum - lead perovskite is used for the electrode (5).

4. Method for the production of a ferroelectric thick-layer structure according to claim 1, **characterized in that** a layer (2) of a lead perovskite, an electrode (5) and a layer (4) of a lead perovskite up to a thickness of 80 µm are applied in succession to an aluminium oxide substrate (1) and the entire structure is fired in an atmosphere rich in lead oxide at a temperature of up to 1200°C.

5. Method according to claim 4, **characterized in that** a composite of platinum and a lead perovskite is used for the electrode (5).

6. Method according to claim 4, **characterized in that** a composite of gold and a lead perovskite is used for the electrode (5).

7. Ferroelectric thick-layer structure based on lead perovskites, **characterized in that** an electrode (5) made of a composite of a precious metal and a lead perovskite with a mass share of the precious metal of 60% to 80% is applied to an aluminium oxide substrate (1), and then a layer (4) of ferroelectric lead perovskite is applied.

8. Method for the production of a ferroelectric thick-layer structure according to claim 7, **characterized in that** first a layer of a composite of gold and a lead perovskite is applied as an electrode (5) to an aluminium oxide substrate (1) and they are fired in an atmosphere rich in lead oxide at a temperature of up to 1050°C, then a layer (4) of lead perovskite is applied up to a thickness of 80 µm and also fired in an atmosphere rich in lead oxide at a temperature of up to 1050°C.

## Patentansprüche

1. Ferroelektrische Dickschichtstruktur auf der Basis von Pb-Perowskiten, wobei eine Zwischenschicht 2 aus einem Pb-Perowskit auf ein Aluminiumoxidsubstrat 1 aufgebracht wird und danach die Elektrode 5 und eine Schicht 4 aus einem ferroelektrischen Pb-Perowskit aufgebracht werden, **dadurch gekennzeichnet, dass** die Elektrode 5 aus einem Verbundwerkstoff aus einem Edelmetall und einem Pb-Perowskit mit einem Masseanteil des Edelmetalls von über 60 % bzw. in einem solchen Anteil, dass die Elektrode elektrisch zu leiten vermag, hergestellt ist.

2. Verfahren zur Herstellung einer ferroelektrischen Dickschichtstruktur nach Anspruch 1, **dadurch gekennzeichnet, dass** eine Zwischenschicht 2 aus einem Pb-Perowskit auf ein Aluminiumoxidsubstrat 1 aufgebracht und bis zur Bildung geschlossener Poren in einer an Bleioxid reichen Atmosphäre gebrannt wird, wonach eine Elektrode 5 aufgebracht und bei einer Temperatur von bis zu 1200°C gebrannt wird und schließlich eine abschließende Schicht 4 aus einem Pb-Perowskit bis zu einer Dicke von 80 µm aufgebracht und bei einer Temperatur von bis zu 1200°C in einer an Bleioxid reichen Atmosphäre gebrannt wird.

3. Verfahren nach Anspruch 2, **dadurch gekennzeichnet, dass** für die Elektrode 5 ein Verbundstoff aus Platin und Pb-Perowskit verwendet wird.

4. Verfahren zur Herstellung einer ferroelektrischen Dickschichtstruktur nach Anspruch 1, **dadurch gekennzeichnet, dass** eine Schicht 2 aus Pb-Perowskit, eine Elektrode 5 und eine Schicht 4 aus Pb-Perowskit bis zu einer Dicke von 80 µm nacheinander auf ein Aluminiumoxidsubstrat 1 aufgebracht werden und der gesamte Aufbau dann in einer an Bleioxid reichen Atmosphäre bei einer Temperatur von bis zu 1200°C gebrannt wird.

5. Verfahren nach Anspruch 4, **dadurch gekennzeichnet, daß** für die Elektrode 5 ein Verbundstoff aus Platin und Pb-Perowskit verwendet wird.

6. Verfahren nach Anspruch 4, **dadurch gekennzeichnet, dass** für die Elektrode 5 ein Verbundstoff aus Gold und Pb-Perowskit verwendet wird.

7. Ferroelektrische Dickschichtstruktur auf der Basis von Pb-Perowskiten, **dadurch gekennzeichnet, dass** eine aus einem Verbundstoff aus einem Edelmetall und einem Pb-Perowskit mit einem Masseanteil des Edelmetalls von 60 bis 80 % hergestellte Elektrode 5 auf ein Aluminiumoxidsubstrat 1 und danach eine Schicht 4 aus einem ferroelektrischen Pb-Perowskit aufgebracht werden.

8. Verfahren zur Herstellung einer ferroelektrischen Dickschichtstruktur nach Anspruch 7, **dadurch gekennzeichnet, dass** zuerst eine Schicht aus einem Verbundstoff aus Gold und einem Pb-Perowskit als Elektrode 5 auf ein Aluminiumoxidsubstrat 1 aufgebracht und in einer an Bleioxid reichen Atmosphäre bei einer Temperatur von bis zu 1050°C gebrannt werden und dann eine Schicht 4 aus Pb-Perowskit bis zu einer Dicke von 80 µm aufgebracht und ebenfalls in einer an Bleioxid reichen Atmosphäre bei einer Temperatur von bis zu 1050°C gebrannt wird.

## Revendications

1. Structure à couche épaisse ferroélectrique à base de pérovskites de plomb, dans laquelle une couche intermédiaire (2) d'une pérovskite de plomb est appliquée à un substrat d'oxyde d'aluminium (1), ensuite sont appliquées l'électrode (5) et une couche (4) d'une pérovskite de plomb ferroélectrique, **caractérisée en ce que** l'électrode (5) est constituée d'un composite d'un métal précieux et d'une pérovskite de plomb, la part en masse du métal précieux étant supérieure à 60%, ou dans une proportion telle qu'elle permet à l'électrode d'être conductrice de l'électricité.

2. Procédé de production d'une structure à couche épaisse ferroélectrique selon la revendication 1, **caractérisé en ce qu'**une couche intermédiaire (2) d'une pérovskite de plomb est appliquée à un substrat d'oxyde d'aluminium (1) et calcinée jusqu'à l'obtention d'une porosité close dans une atmosphère riche en oxyde de plomb, ensuite une électrode (5) est appliquée et calcinée à une température allant jusqu'à 1 200°C, puis une couche finale (4) d'une pérovskite de plomb est appliquée jusqu'à une épaisseur de 80 µm et calcinée à une température allant jusqu'à 1 200°C, dans une atmosphère riche en oxyde de plomb.

3. Procédé selon la revendication 2, **caractérisé en ce qu'**un composite de platine/pérovskite de plomb est employé pour l'électrode (5).

4. Procédé de production d'une structure à couche épaisse ferroélectrique selon la revendication 1, **caractérisé en ce qu'**une couche (2) d'une pérovskite de plomb, une électrode (5) et une couche (4) d'une pérovskite de plomb jusqu'à une épaisseur de 80 µm sont appliquées successivement à un substrat d'oxyde d'aluminium (1), et la structure entière est calcinée dans une atmosphère riche en oxyde de plomb à une température allant jusqu'à 1 200°C.

5. Procédé selon la revendication 4, **caractérisé en ce qu'**un composite de platine et d'une pérovskite de plomb est employé pour l'électrode (5).

6. Procédé selon la revendication 4, **caractérisé en ce qu'**un composite d'or et d'une pérovskite de plomb est employé pour l'électrode (5).

7. Structure à couche épaisse ferroélectrique à base de pérovskites de plomb, **caractérisée en ce qu'**une électrode (5) constituée d'un composite d'un métal précieux et d'une pérovskite de plomb avec une part en masse du métal précieux de 60% à 80%, est appliquée à un substrat d'oxyde d'aluminium (1) puis une couche (4) de pérovskite de plomb ferroélectrique est appliquée.

8. Procédé de production d'une structure à couche épaisse ferroélectrique selon la revendication 7, **caractérisé en ce qu'**une couche d'un composite d'or et d'une pérovskite de plomb est d'abord appliquée sous forme d'une électrode (5) à un substrat d'oxyde d'aluminium (1) et qu'ils sont calcinés dans une atmosphère riche en oxyde de plomb à une température allant jusqu'à 1 050°C, puis une couche (4) de pérovskite de plomb est appliquée jusqu'à une épaisseur de 80 µm et également calcinée dans une atmosphère riche en oxyde de plomb à une température allant jusqu'à 1 050°C.
